# FASCICULE DE BREVET EUROPEEN

(11) **EP 3 529 867 B1**
(45) Date de publication et mention de la délivrance du brevet: **29.07.2020**
(21) Numéro de dépôt: 17784658.1
(22) Date de dépôt: 23.10.2017
(51) Int. Cl.: H02B 1/052

(54) **APPAREIL ELECTRIQUE COMPRENANT UN DISPOSITIF DE VERROUILLAGE POUR RAIL DE FIXATION**
ELEKTRISCHES GERÄT MIT EINER VERRIEGELUNGSVORRICHTUNG FÜR EINE MONTAGESCHIENE
ELECTRICAL APPARATUS COMPRISING A LOCKING DEVICE FOR A MOUNTING RAIL

(30) Priorité: 24.10.2016 FR 1660283
(43) Date de publication de la demande: 28.08.2019
(73) Titulaire: Mersen France SB SAS, 69720 Saint-Bonnet-de-Mure (FR)
(72) Inventeur: AUBERT, Laurent, 69150 Decines (FR); SOUMILLON, Olivier, 38440 Savas Mepin (FR)
(74) Mandataire: Lavoix
(86) Numéro de dépôt international: PCT/EP2017/076969
(87) Numéro de publication internationale: WO 2018/077786

(56) Documents cités:
- EP-A1- 1 775 809
- EP-A2- 2 264 846
- EP-A2- 2 528 178
- US-A1- 2008 186 657

## Description

L'invention concerne un appareil électrique comprenant un dispositif de verrouillage pour verrouiller cet appareil électrique sur un rail de fixation.

On connaît des appareils électriques, tels que des porte-fusibles, destinés à être montés sur un rail de fixation, par exemple au sein d'un tableau électrique. Un tel appareil comprend généralement un dispositif de verrouillage bistable, adapté pour verrouiller l'appareil électrique sur le rail de fixation ou, en alternance, déverrouiller l'appareil, de sorte à autoriser un déplacement de l'appareil par rapport au rail de fixation.

Typiquement, les dispositifs de verrouillage connus comportent une pièce mécanique déplaçable qui est rapportée sur le boîtier de l'appareil. Un inconvénient est que cela complique la fabrication industrielle de l'appareil, car la pièce mécanique, généralement réalisée dans un matériau différent du boîtier, doit être fabriquée séparément du boîtier puis ensuite être fixée sur ce boîtier.

On connaît de EP-2 528 178-A1 un appareil électrique qui comprend un dispositif de verrouillage bistable déplaçable, réalisé de façon monobloc avec le boîtier de l'appareil.

Ce dispositif de verrouillage connu est pourvu d'une languette qui comprend, sur une de ses extrémités, un crochet adapté pour retenir une branche du rail de fixation et qui comporte également, sur son extrémité opposée, une portion de manœuvre recourbée ainsi qu'un organe de verrouillage. L'organe de verrouillage est disposé sous la portion de manœuvre et est adapté pour retenir la languette dans une position déverrouillée par rapport au rail de fixation. La portion de manœuvre permet à un opérateur de déplacer la languette entre les positions verrouillées et déverrouillée.

Cet appareil connu ne donne cependant pas entière satisfaction. En particulier, du fait de la configuration du dispositif de verrouillage, un opérateur doit, pour accrocher l'appareil sur le rail de fixation, c'est-à-dire déplacer le la languette vers la position de verrouillage, déplacer la portion de manœuvre en tirant celle-ci vers lui, c'est-à-dire vers une face avant de l'appareil. Un tel déplacement est peu intuitif, ce qui augmente le risque de fausse manœuvre et d'endommagement du dispositif. Un tel déplacement est de surcroît malcommode à réaliser lorsque l'espace requis pour une telle manœuvre est insuffisant, par exemple lorsque l'appareil est monté dans un tableau électrique.

On connaît également les appareils décrits dans les documents EP-2 264 846-A2, US-2008/186657-A1 et EP-1 775 809-A1.

C'est à cet inconvénient qu'entend plus particulièrement remédier l'invention en proposant un appareil électrique pourvu d'un dispositif de verrouillage sur un rail de fixation, ce dispositif de verrouillage intégré au boîtier et présentant une ergonomie améliorée, dans lequel la commutation du dispositif de verrouillage entre des positions de verrouillage et de déverrouillage est réalisable plus facilement et plus intuitivement.

A cet effet, l'invention concerne un appareil électrique conforme à la revendication 1.

Grâce à l'invention, du fait que l'organe de verrouillage s'étend en saillie sur un côté latéral de la languette, vers l'extérieur de l'appareil, et que le logement correspondant de la pièce d'encliquetage est ménagé sur un couvercle latéral de l'appareil, le déplacement de la languette vers la position de déverrouillage est réalisable par un opérateur en poussant la portion de manœuvre vers l'arrière de l'appareil, sans avoir besoin de tirer la languette vers lui. Un tel déplacement est plus facile et plus intuitif à réaliser que dans l'état de la technique connu dans lequel la portion de manœuvre doit être déplacée vers l'avant de l'appareil.

Selon des aspects avantageux mais non obligatoires de l'invention, un tel appareil électrique peut incorporer une ou plusieurs des caractéristiques des revendications dépendantes 2 à 9.

L'invention sera mieux comprise et d'autres avantages de celle-ci apparaitront plus clairement à la lumière de la description qui va suivre, d'un mode de réalisation d'un appareil électrique donné uniquement à titre d'exemple et faite en référence aux dessins annexés dans lesquels :
- la figure 1 est une représentation schématique, selon une vue latérale, d'un appareil électrique conforme à l'invention ;
- la figure 2 est une représentation schématique, selon une vue en coupe longitudinale, de l'appareil électrique de la figure 1 ;
- la figure 3 est une représentation schématique, selon une vue écorchée en perspective, d'un dispositif de verrouillage de l'appareil électrique de la figure 2 ;
- les figures 4 à 6 sont des représentations schématiques, selon des vues en coupe longitudinale, de l'appareil électrique de la figure 2, illustrant des étapes du déplacement du dispositif de verrouillage entre des positions de verrouillage et de déverrouillage ;
- les figures 7 et 8 représentent schématiquement un autre mode de réalisation de l'appareil électrique des figures 1 à 6 qui ne fait pas partie de l'invention ;
- la figure 9 représente schématiquement une variante de l'appareil de la figure 2.

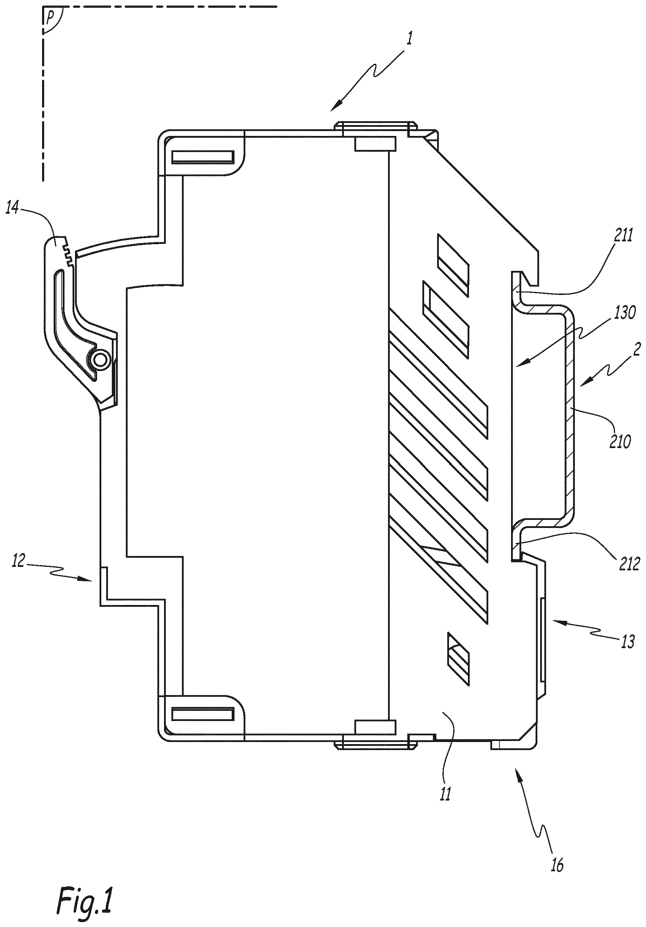

La figure 1 représente un appareil électrique 1, ici un porte-fusible. En variante, l'appareil 1 peut être un appareil de commutation électrique, tel qu'un disjoncteur ou un relais.

L'appareil 1 est destiné à être attaché, de façon réversible, sur un rail de fixation 2, par exemple au sein d'un tableau électrique.

L'appareil 1 comporte un boîtier, dont une partie centrale 10 est recouverte par des couvercles latéraux, dont l'un d'eux porte ici la référence 11. Le boîtier est de préférence réalisé en matière plastique rigide, par exemple du polyamide 6.6.

Les faces avant et arrière de l'appareil 1 portent, respectivement, les références 12 et 13.

L'appareil 1 est ici pourvu, sur sa face avant 12, d'un levier de commande 14 basculant qui comporte un corps creux 140 adapté pour recevoir un fusible. Le levier 14 est monté pivotant autour d'un arbre 141 qui s'étend transversalement par rapport à l'appareil 1. Lorsque le levier 14 est dans une position fermée, le fusible est situé à l'intérieur du boîtier et en contact avec des terminaux électriques, non illustrés, de l'appareil 1. Un tel mécanisme de porte-fusible est bien connu et n'est pas décrit en détail.

L'appareil 1 est également pourvu, sur sa face arrière 13, d'une zone 130 de réception du rail 2. La zone 130 présente une forme et des dimensions complémentaires à celles du rail 2.

Le rail 2 comporte une partie centrale 210 essentiellement plane et deux parties d'extrémité, nommées branche supérieure 211 et branche inférieure 212 qui s'étendent de part et d'autre de la partie centrale 210 pour permettre l'accrochage de l'appareil 1.

A titre d'exemple, des moyens de fixation, non illustrés, sont agencés sur la partie centrale 210 pour solidariser ce rail 2 à un support fixe, par exemple à une paroi d'un tableau électrique.

Dans cet exemple, le rail 2 est un rail de fixation de type « DIN », tel que défini par la norme EN 50022. Il s'agit par exemple d'un rail de fixation en matière métallique et de hauteur 35mm, défini par cette norme et connu sous la dénomination « oméga » ou « top hat » en langue anglaise.

Dans cette description, le rail de fixation 2 s'étend longitudinalement selon un axe disposé horizontalement.

On note « X1 » un axe fixe longitudinal de l'appareil 1. Lorsque l'appareil 1 est fixé sur le rail 2, l'axe X1 est perpendiculaire à la direction longitudinale du rail 2. Ici, l'axe X1 s'étend verticalement.

On note « Y1 » et « Z1 » des axes fixes de l'appareil 1, tous deux perpendiculaires à l'axe X1. L'axe Y1 s'étend transversalement à l'appareil 1, ici perpendiculairement aux faces latérales de l'appareil 1 L'axe Y1 forme ainsi un axe transversal de l'appareil. L'axe Z1 relie ici les faces avant 12 et arrière 13 de l'appareil 1. Les axes Y1 et Z1 s'étendent ici horizontalement.

On comprend ainsi que l'axe Y1 est parallèle à l'axe longitudinal du rail 2 lorsque l'appareil 1 est monté sur le rail 2.

On note « P » un plan géométrique médian de l'appareil 1. Le plan P contient ici les axes X1 et Z1.

Dans ce qui suit, on nomme « partie inférieure » de l'appareil 1 la partie située en dessous du rail 2 lorsque l'appareil 1 est attaché à ce rail 2. De même, on nomme « partie supérieure » la partie de l'appareil 1 qui est située au-dessus du rail 2.

L'appareil 1 comporte un crochet 15 fixe, ménagé d'un seul tenant avec le boîtier et situé sur une partie supérieure de la zone 130. Le crochet 15 est adapté pour coopérer avec la branche supérieure 211 du rail 2. Par exemple, lorsque le rail 2 est reçu dans la zone 130, le crochet 15 prend appui sur une face arrière de la branche supérieure 212.

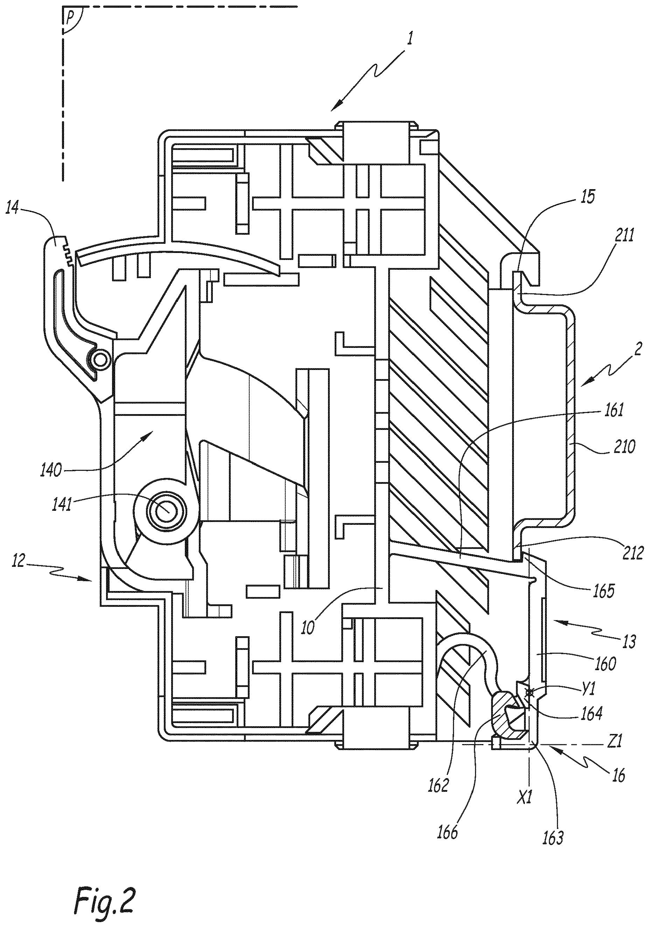

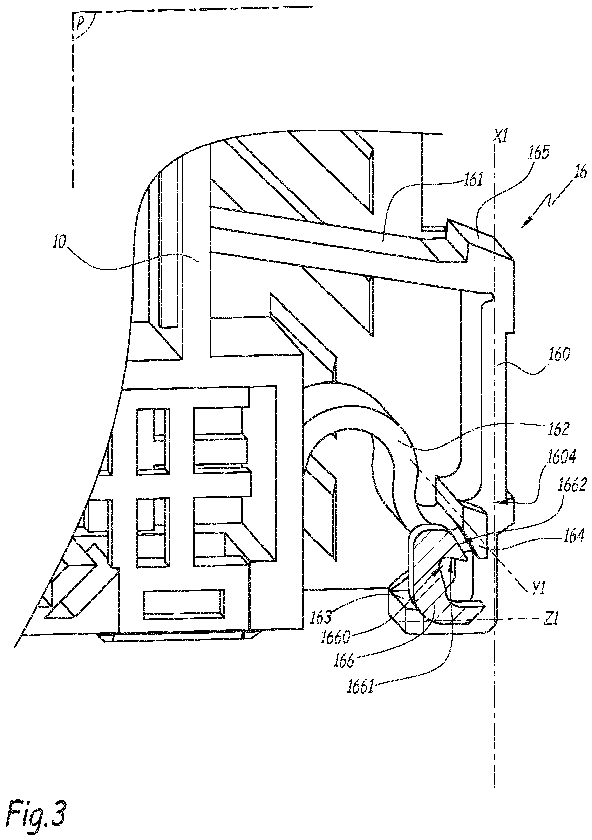

Comme illustré aux figures 2 à 6, l'appareil 1 comporte également un dispositif de verrouillage 16 bistable, destiné à permettre le maintien de l'appareil 1 sur le rail 2. Le dispositif de verrouillage 16 est formé monobloc avec la partie centrale 10 du boîtier, c'est-à-dire d'un seul tenant avec le boîtier, comme expliqué dans ce qui suit.

Le dispositif de verrouillage 16 est notamment pourvu d'un crochet 165 mobile, ici adapté pour coopérer avec la branche inférieure 212 du rail 2.

Le dispositif de verrouillage 16 est déplaçable, de façon sélective et réversible, entre deux positions stables et distinctes, nommées respectivement position de verrouillage et position de déverrouillage.

Dans la position de verrouillage, le dispositif de verrouillage 16 est adapté pour maintenir l'appareil 1 attaché sur le rail 2, lorsque le rail 2 est reçu dans la zone 130. Dans cette position, lorsque le rail 2 est reçu dans la zone 130 et que le crochet 15 retient la branche supérieure 211 du rail 2, le crochet 165 est maintenu en appui sur la branche inférieure 212 du rail 2, ici sur l'arrière de cette branche inférieure 212, de manière à empêcher le décrochage de l'appareil 1 hors du rail 2. L'appareil 1 est alors dit être attaché sur le rail 2.

Dans la position de déverrouillage, le dispositif de verrouillage 16 autorise un déplacement de l'appareil 1 par rapport au rail 2. Par exemple, le crochet 165 est situé à distance de la branche inférieure 212. L'appareil 1 peut alors être détaché du rail 2.

Le dispositif de verrouillage 16 comporte également une languette 160 déplaçable le long de l'axe X1 entre les positions de verrouillage et de déverrouillage.

Dans cette description, lorsqu'il est fait référence au déplacement du dispositif de verrouillage 16 entre les positions de verrouillage et de déverrouillage, il faut comprendre que c'est la languette 160 qui est déplacée entre les positions de verrouillage et de déverrouillage.

La languette 160 comporte ici une partie principale de forme essentiellement plane qui s'étend longitudinalement le long de l'axe X1, dont des faces principales s'étendent perpendiculairement à l'axe Z1.

Les faces latérales 1604 de la languette 160 s'étendent ici perpendiculairement aux faces principales et donc perpendiculairement à l'axe Y1. Les faces latérales 1604 sont définies comme étant les faces de la languette 160 qui sont tournées latéralement par rapport à l'appareil 1, c'est-à-dire qui sont ici parallèles au plan géométrique P.

La languette 160 comporte en outre, sur une partie inférieure, une portion de manœuvre 163 qui forme ici une partie recourbée s'étendant vers la face avant 12, perpendiculairement à la partie principale, selon l'axe Z1. La portion de manœuvre 163 est solidaire de la partie principale de la languette 160 et dépasse à l'extérieur du boîtier de l'appareil 1, permettant son maniement par un opérateur pour commander le déplacement de la languette 160, comme expliqué dans ce qui suit.

On comprend notamment que la portion de manœuvre 163 illustrée aux figures n'est donnée qu'à titre d'exemple et qu'en variante elle peut présenter un aspect différent.

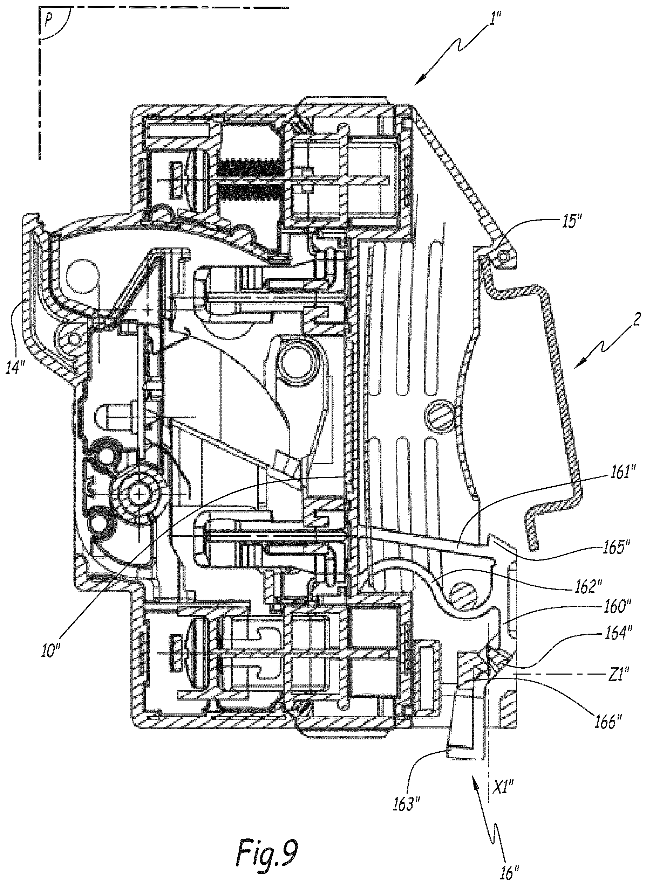

En particulier, la portion de manœuvre 163 peut dépasser à l'extérieur du boîtier de façon plus importante que ce qui est visible aux figures 1 à 6. Par exemple, la portion de manœuvre 163 dépasse par rapport à la base du boîtier 10 d'une distance supérieure ou égale 1cm ou supérieure ou égale à 2 cm, cette distance étant mesurée ici selon l'axe X1. En effet, plus la portion de manœuvre 163 dépasse du boîtier de l'appareil 1, plus elle est visible et accessible par un utilisateur, ce qui facilite sa manipulation. Un tel exemple de portion de manœuvre est illustré à la figure 9.

La languette 160 est ici rigide et réalisée dans le même matériau que le boîtier.

L'appareil 1 comporte également au moins une lame élastiquement déformable qui relie mécaniquement la languette 160 à la partie principale 10 du boîtier de l'appareil 1 et qui est adaptée pour exercer une première force de rappel élastique sur la languette 160, en ramenant la languette 160 depuis la position de déverrouillage vers la position de verrouillage le long de l'axe X1.

Plus précisément, ici, le dispositif de verrouillage 16 comporte deux telles lames 161 et 162 élastiquement déformables.

La lame 161 relie ici la partie principale 10 à une partie supérieure de la partie principale de la languette 160, alors que la lame 162 relie la partie principale 10 à une partie inférieure de la partie principale de la languette 160. Ici, le crochet 165 est ménagé sur l'extrémité supérieure de la languette 160, au-dessus de la jonction entre la lame 161 et la languette 160.

La lame 161 est rectiligne et présente une forme de plaque plane qui s'étend essentiellement perpendiculairement à la partie principale de la languette 160, par exemple avec un angle inférieur ou égal à 20° ou à 10° par rapport à l'axe Z1.

De par son articulation avec la partie centrale 10, la lame 161 exerce une première force de rappel élastique selon l'axe X1, qui tend à ramener la languette 160 vers sa position de verrouillage.

La lame 162 présente une forme recourbée, par exemple dont la projection géométrique dans le plan P décrit une forme « en S » décrivant un premier arc de cercle tourné vers la partie supérieure de l'appareil 1, puis un deuxième arc de cercle accolé au premier arc de cercle et orienté à l'opposé du premier arc de cercle, c'est-à-dire ici tourné vers la partie inférieure de l'appareil 1. Ainsi, la lame 162 contribue également à exercer la première force de rappel élastique.

Les lames 161 et 162 sont ici superposées entre elles selon l'axe X1, la lame 161 étant ici placée au-dessus de la lame 162.

On comprend que les positions relatives des lames 161 et 162 illustrées aux figures ne sont donnes qu'à titre d'exemple illustratif. En variante, notamment, les lames 161 et 162 peuvent être plus rapprochées l'une de l'autre que ce qui est illustré sur la figure 2. Par exemple, la lame 162 relie la partie principale 10 à la partie supérieure de la partie principale de la languette 160, tout en se trouvant sous la lame 161. Un tel exemple est illustré à la figure 9.

Les lames 161 et 162 sont formées d'un seul tenant avec la languette 160 et avec la partie principale 10 du boîtier de l'appareil 1. Ainsi, les lames 161 et 162 sont réalisées en un même matériau que la languette 160 et que la partie principale 10 du boîtier.

La languette 160 peut subir un débattement, de façon élastique, par rapport à la partie centrale 10, suivant une direction de débattement parallèle à l'axe Z1. Ce débattement est ici permis grâce à l'articulation entre la lame 161 et la languette 160. La lame 162 exerce une deuxième force de rappel qui ramène la partie principale de la languette 160 alignée avec l'axe X1 lorsque la languette 160 subit un tel débattement parallèle à l'axe Z1.

La languette 160 est également pourvue d'un organe de verrouillage 164, aussi nommé organe d'encliquetage.

L'organe 164 est ménagé sur une face latérale 1604 de la languette 160 et s'étend en saillie, selon l'axe Y1, par rapport à cette face latérale. A titre d'exemple, l'organe 164 présente une forme prismatique avec une base en forme de polyèdre formée sur la face latérale 1604. L'axe Y1 forme ici un axe longitudinal pour cet organe 164. Cette forme peut, en variante, être choisie différemment.

On comprend donc de ce qui précède que la direction de débattement est perpendiculaire à la direction Y1 selon laquelle l'organe 164 s'étend en saillie.

Ici, l'organe 164 présente une hauteur, mesurée par rapport à la face latérale 1604 et selon l'axe Y1, supérieure ou égale à 2mm ou, de préférence, supérieure ou égale à 5mm.

Cet organe 164 est ici formé d'un seul tenant avec la languette 160.

Cet organe 164 est ici situé au niveau de la jonction entre la lame 162 et la languette 160. Toutefois, cela peut être différent selon que la lame 162 est positionnée plus ou moins près de la lame 161.

L'appareil 1 comporte également, ménagé sur une face intérieure du couvercle latéral 11 une paroi de retenue 1661 qui définit au moins en partie un logement 1660 de forme complémentaire à la forme de l'organe 164. Lorsque le couvercle 11 est dans une configuration assemblée avec la partie centrale 10 du boîtier, la face intérieure du couvercle latéral 11 est tournée vers l'organe 164 et le logement 1660 est situé en regard de l'organe 164.

L'organe 164 est déplaçable entre une position retenue à l'intérieur du logement 1660 et une position libérée à l'extérieur du logement 1660.

Dans la position de retenue, l'organe 164 est au moins en partie reçu à l'intérieur du logement 1660. Il maintient alors la languette 160 dans la position déverrouillée, en empêchant son déplacement en translation le long de l'axe X1 vers la position de verrouillage.

Dans la position libérée, l'organe 164 est situé en dehors du logement 1660. L'organe 164 autorise alors un déplacement de la languette 160 en translation selon l'axe X1.

Dans cet exemple, le logement 1660 est ménagé au sein d'une pièce complémentaire 166 qui s'étend en saillie par rapport à la face intérieure du couvercle 11, parallèlement à l'axe Y1 et vers l'organe 164. Par exemple, la pièce complémentaire 166 est formée d'un seul tenant avec le couvercle 11. Le logement 1660 a une forme de cavité ouverte, dont la projection des parois interne dans le plan géométrique P présente ici une forme de « C ». Le logement 1660 a une forme correspondant au contour de l'organe 164, de manière à retenir l'organe 164 dans le logement 1660. Le logement 1660 est ici ouvert vers l'arrière afin de permettre l'entrée ou, alternativement, la sortie de l'organe 164 par rapport au logement 1660.

La paroi de retenue 1661 délimite ici une partie supérieure du logement 1660. La paroi de retenue 1661 est agencée pour maintenir l'organe 164 en appui pour empêcher son déplacement, et donc celui de la languette 160, le long de l'axe X1 vers la position de verrouillage, sous l'effet de la première force de rappel, lorsque l'organe 163 est reçu dans le logement 1660.

La pièce 166 comporte en outre une paroi extérieure inclinée 1662, ici ménagée sur une extrémité supérieure de la pièce 166. La paroi inclinée 1662 est agencée pour dévier l'organe 164 parallèlement à l'axe Z1, vers l'arrière de la pièce 166, lorsque la languette 160 se déplace le long de l'axe X1 depuis sa position de verrouillage vers sa position de verrouillage.

L'organe 164 est ici déplaçable entre les positions de retenue et libérée notamment par translation le long de l'axe X1 et par débattement parallèlement à l'axe Z1.

Le déplacement du dispositif 16 entre ses positions de déverrouillage et de verrouillage est ici destiné à être réalisé par un opérateur en agissant sur la portion de manœuvre 163.

Dans cet exemple, cet action est réalisée au moyen d'un outil 3, tel qu'un tournevis, en insérant une pointe 30 de l'outil 3 dans un logement 1630 délimité en partie par la portion recourbée de la portion de manœuvre 163. En variante, ce déplacement peut être réalisé manuellement, sans avoir recours à l'outil 3.

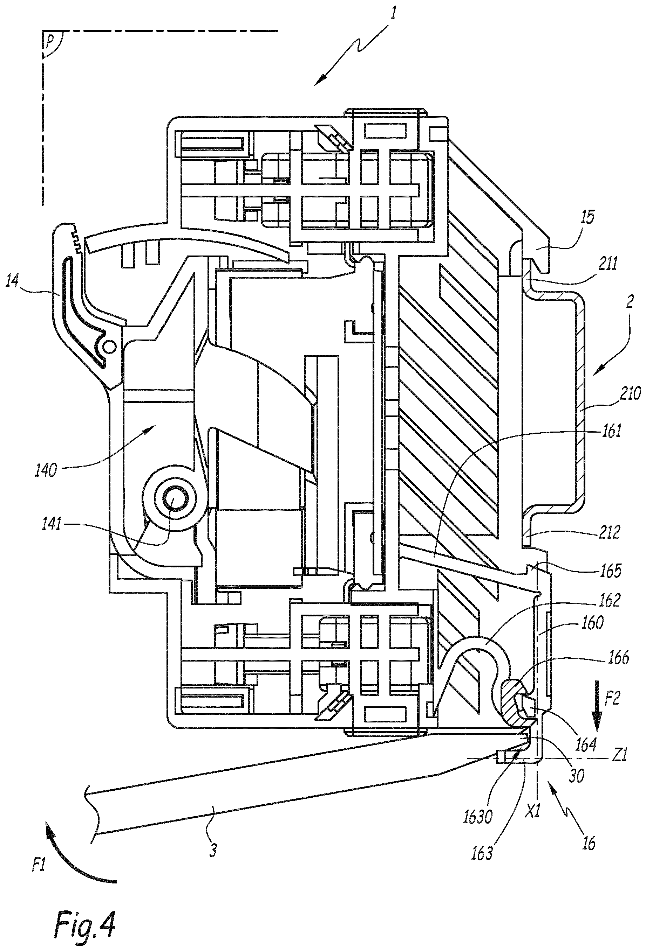

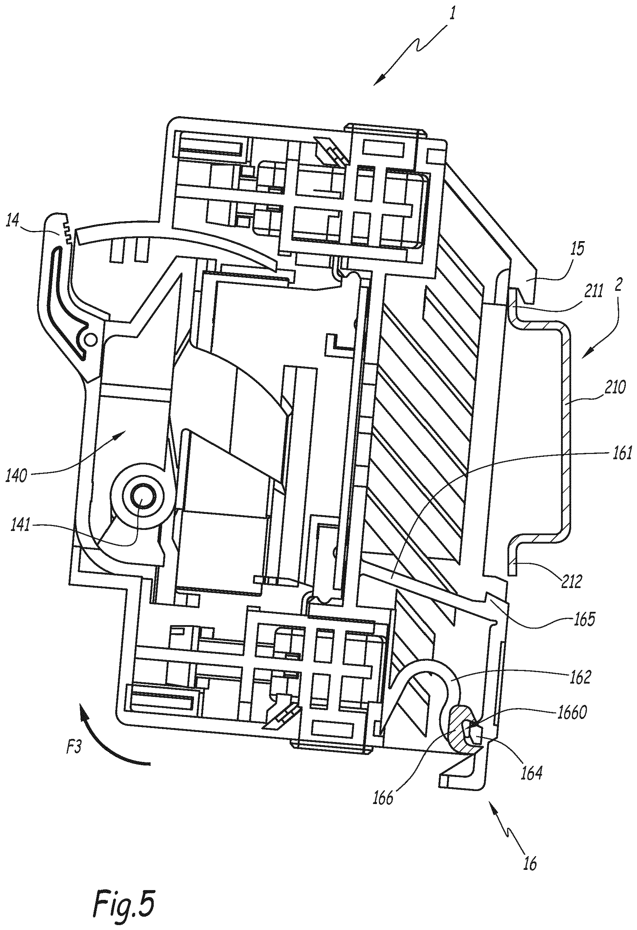

Les figures 4 et 5 illustrent des étapes du déplacement de l'appareil 1 pour le décrocher hors du rail 2 sur lequel il est initialement fixé, avec le dispositif 16 initialement dans la position de verrouillage.

A la figure 4, le dispositif 16 est représenté dans la position de déverrouillage, à l'issue du déplacement, avec un outil 3 dont la pointe 30 est insérée dans le logement 163.

Le déplacement du dispositif 16 depuis la position de verrouillage vers la position de déverrouillage est réalisé en tirant la portion de manœuvre 163 vers le bas, pour déplacer la languette 16. Cela est ici réalisé en exerçant un effort en translation selon l'axe X1 au moyen de l'outil 3, ici en exerçant un couple en rotation illustré par la flèche F1, en prenant appui sur une base inférieure du boîtier de l'appareil 1.

Ce faisant, la languette 160 se déplace le long de l'axe X1, ici vers le bas, comme illustré par la flèche F2. L'organe 164 se déplace solidairement avec la languette 160 jusqu'à atteindre la pièce 166.

Au fur et à mesure que la languette 160 continue à se déplacer selon la flèche F2, l'organe 164 glisse d'abord sur la face extérieure inclinée 1662 de la pièce 166, puisque cette face 1662 se trouve sur sa trajectoire. Cela provoque un débattement de la languette 160, et donc de l'organe 164, selon la direction de débattement parallèle à l'axe Z1, ici vers l'arrière de la pièce 166. Puis, sous l'action de la deuxième force de rappel exercée par la lame 162, l'organe 164 est déplacé vers l'avant de l'appareil 1 et rentre à l'intérieur du logement 1660. La paroi de retenue 1661 empêche alors tout retour de la languette 160 vers la position de verrouillage. Le dispositif 16 est ainsi maintenu dans la position de déverrouillage, telle qu'illustrée par la figure 4.

L'appareil 1 peut alors être décroché du rail 2, comme illustré à la figure 5, par pivotement par rapport au crochet fixe 15, selon le sens illustré par la flèche F3.

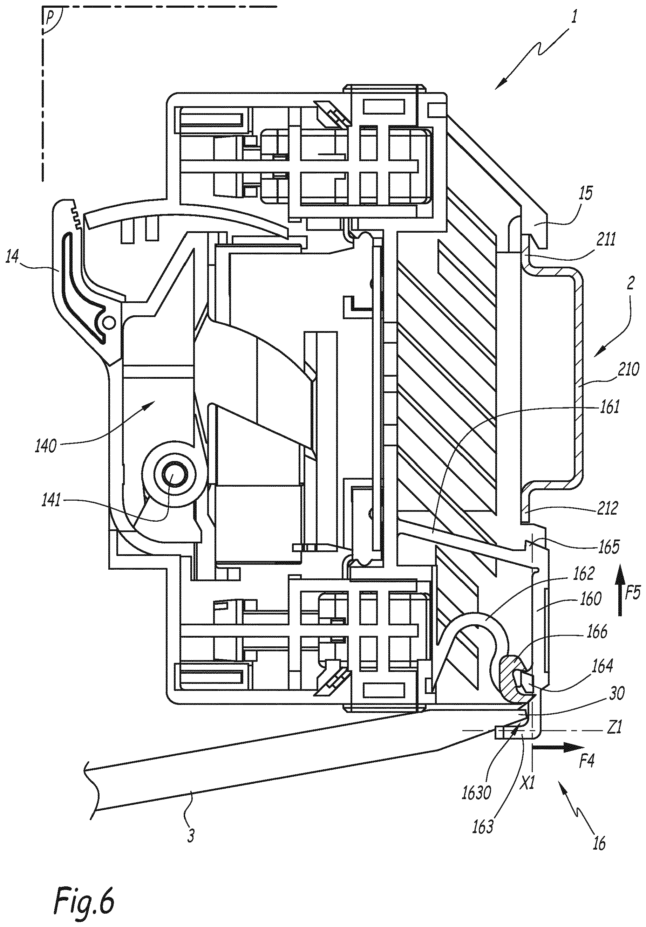

La figure 6 illustre une étape du déplacement du dispositif 16 depuis la position de déverrouillage vers la position de verrouillage, pour l'attacher sur le rail 2. Le dispositif 16 est illustré initialement dans la position de déverrouillage et le rail 2 est reçu dans la zone 130 de l'appareil 1, et la branche supérieure 211 du rail 2 est engagée avec le crochet fixe 15.

Le déplacement du dispositif 16 vers la position de verrouillage est réalisé en poussant la portion de manœuvre 163 vers l'arrière de l'appareil 1, ici dans le sens illustré par la flèche F4. Par exemple, ce déplacement est réalisé au moyen de la pointe 30 de l'outil 3. En variante, ce déplacement peut être réalisé manuellement, l'outil 3 étant alors omis.

Ce faisant, l'organe 164 est déplacé hors du logement 1660, vers sa position libérée. La languette 160 est alors ramenée parallèlement à l'axe X1 et vers sa position de verrouillage, sous l'effet des première et deuxième forces de rappel élastiques, jusqu'à ce que le crochet 165 soit engagé avec la branche inférieure 212 du rail 2. Le dispositif 16 est alors dans la position de verrouillage.

Grâce à cette configuration du dispositif 16, le déplacement vers la position de verrouillage est plus simple et plus intuitif à réaliser pour un opérateur. L'ergonomie du dispositif 16 en est ainsi améliorée. De plus, comme le dispositif 16 est réalisé monobloc avec le boîtier de l'appareil 1, sa fabrication est plus simple que dans le cas où diverses pièces mécaniques doivent être rapportées sur le boîtier pour former le dispositif 16.

Selon une variante, le dispositif 16 peut être réalisé sur la partie supérieure de l'appareil 1 pour coopérer avec la branche supérieure 211 du rail 2. Le crochet fixe 15 est alors réalisé sur la partie inférieure de l'appareil 1 pour coopérer avec la branche inférieure 212 du rail 2. La forme de l'organe 164 et du logement 1660 sont alors adaptés en conséquence. Le sens des flèches F2 et F4 est alors inversé. Par exemple, le dispositif 16 est alors disposé symétriquement, selon un plan de symétrie horizontal, par rapport au mode de réalisation précédemment décrit.

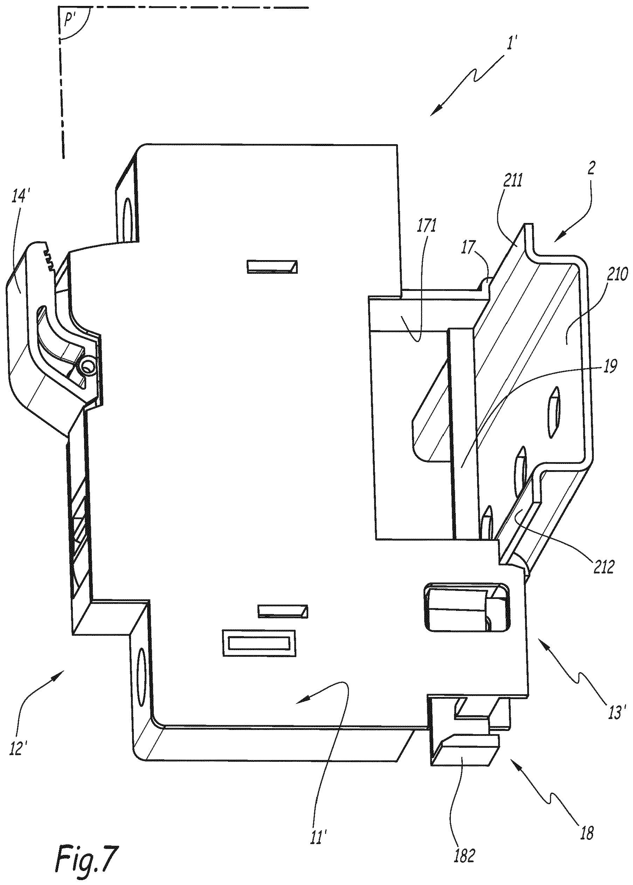

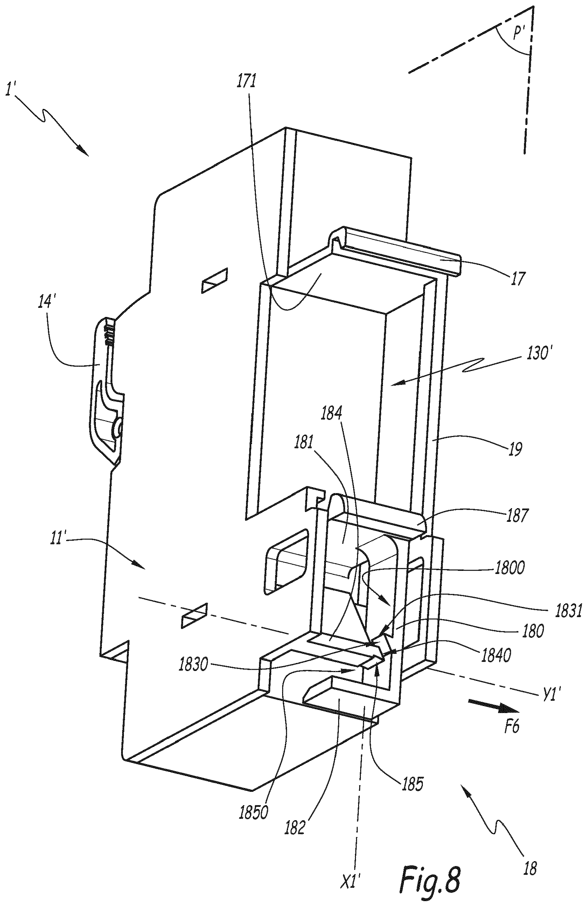

Les figures 7 et 8 représentent un appareil électrique 1' selon un deuxième mode de réalisation qui ne fait pas partie de l'invention. Les éléments de l'appareil électrique selon de ce mode de réalisation qui sont analogues à l'appareil 1 selon le premier mode de réalisation portent des références numériques augmentées du symbole « ' » et ne sont pas décrits en détail, dans la mesure où la description ci-dessus peut leur être transposée.

On note notamment « X1' » et « Y1' » des axes fixes analogues aux axes X1 et Y1 de l'appareil 1, et « P' » un plan géométrique médian analogue au plan P de l'appareil 1.

L'appareil 1' diffère notamment de l'appareil 1 en ce que le dispositif de verrouillage 16 est remplacé par un dispositif de verrouillage 18 qui remplit la même fonction. En particulier, le dispositif 18 est monobloc avec le corps central du boîtier de l'appareil 1'. De plus, le dispositif 18 est bistable et déplaçable entre les positions de verrouillage et de déverrouillage pour attacher l'appareil 1' sur le rail 2.

Dans cet appareil 1', le crochet 15 est en outre remplacé par un crochet fixe 17 qui joue le même rôle que le crochet 15. Le crochet 17 est ménagé sur une extrémité distale d'une lame fixe 171 qui s'étend depuis une partie centrale du boîtier de l'appareil 1'. La lame 171 est optionnellement maintenue à une partie inférieure du boîtier par une poutre verticale 19 qui s'étend ici parallèlement à l'axe X1'.

Le dispositif 18 comporte une languette 180 déplaçable en translation selon l'axe X1' et qui joue un rôle analogue à la languette 160 vis-à-vis du dispositif 16. La languette 180 est ainsi déplaçable entre les positions de verrouillage et de déverrouillage.

La languette 180 présente une partie principale de forme essentiellement plane qui s'étend longitudinalement le long de l'axe X1' et une portion de manœuvre 182 recourbée disposée sur une partie inférieure de la languette 180.

La portion de manœuvre 182 forme une partie recourbée s'étendant perpendiculairement et latéralement par rapport à la languette 180, en saillie par rapport à celle-ci, parallèlement à l'axe Y1'. La portion de manœuvre 180 joue un rôle analogue à la portion de manœuvre 163.

Le dispositif 18 comporte une lame 181 élastiquement déformable, par exemple analogue à la lame 161, qui relie mécaniquement la languette 180 à la partie principale du boîtier de l'appareil 1. La lame 181 est adaptée pour exercer une première force de rappel élastique sur la languette 180, en ramenant la languette 180 depuis la position de déverrouillage vers la position de verrouillage.

La lame 181 est rectiligne et présente une forme de plaque plane qui s'étend essentiellement perpendiculairement à la partie principale de la languette 180. Un crochet 187 est ménagé sur l'extrémité distale de cette lame 187. Le crochet 187 remplit une fonction analogue à celle remplie par le crochet 165 de l'appareil 1.

Dans cet exemple, la languette 180 s'étend perpendiculairement en saillie par rapport à une face inférieure de la lame 181. Une extrémité supérieure de la languette 180 est articulée avec la face inférieure de la lame 181.

Ainsi, la languette 180, bien que rigide, peut subir un débattement, de façon élastique, par rapport à la lame 181, selon une direction de débattement ici parallèle à l'axe Y1'. L'articulation de la languette 180 avec la lame 181 exerce une deuxième force de rappel qui ramène la partie principale de la languette 180 alignée avec l'axe X1' lorsque la languette 180 subit un tel débattement.

Le dispositif 18 comporte en outre un organe de verrouillage 183, jouant un rôle analogue à l'organe 164. L'organe 183 est ménagé sur une face latérale 1800 de la languette 180, ici d'un seul tenant avec la languette 1800, et s'étend en saillie, selon l'axe Y1', par rapport à cette face latérale 1800. A titre d'exemple, l'organe 164 comporte une face supérieure 1831 perpendiculaire à la face latérale et comporte également une face inférieure 1803 inclinée par rapport à la face latérale de la languette 180.

L'appareil 1 comporte également, ménagé sur une face intérieure d'un couvercle latéral 11' du boîtier, un logement 1850 de forme complémentaire à la forme de l'organe 183, qui joue un rôle analogue au logement 1660. Lorsque le couvercle 11' est dans une configuration assemblée avec la partie centrale du boîtier de l'appareil 1, la face intérieure du couvercle latéral 11' est tournée vers l'organe 183 et le logement 185 est situé en regard de l'organe 183.

Dans cet exemple, le couvercle 11' comporte une poutre 184 rigide qui s'étend en saillie par rapport à la face intérieure du couvercle 11', parallèlement à l'axe Y1'. Cette poutre 184 comporte la paroi de retenue 185 formée sur une partie inférieure de son extrémité distale. Ainsi, la paroi de retenue 185 définit au moins en partie le logement 1850, destiné à recevoir cet organe 183 pour le maintenir dans la position retenue.

La poutre 184 comporte également ici, sur son extrémité distale, une paroi inclinée 1840 qui permet le guidage de l'organe 183 lorsque la languette 1830 se déplace vers sa position de déverrouillage le long de l'axe X1. Par exemple, la paroi inclinée 1840 est disposée en regard de la paroi 1830.

Le déplacement du dispositif 18 de sa position de verrouillage vers la position de déverrouillage est réalisé de façon analogue au déplacement du dispositif 16, en tirant la languette 180 vers le bas selon l'axe X1', au moyen de la portion de manœuvre 182, avec ou sans outil. Ce faisant, l'organe 183 se déplace le long de l'axe X1 solidairement avec la languette 180 jusqu'à venir en contact avec l'extrémité de la poutre 184. Il est alors dévié latéralement, selon l'axe Y1', par la paroi inclinée de la poutre 184. Du fait de l'élasticité de la languette 180 par rapport à la lame 181, l'organe 183 est amené vers sa position retenue en dessous de la poutre 184, de sorte que la face 1831 soit en contact avec la paroi de retenue 185.

Le déplacement du dispositif 18 de sa position de déverrouillage vers la position de verrouillage est réalisé en poussant la languette 180, au moyen de la portion de manœuvre 182, soit vers l'arrière de l'appareil soit latéralement selon l'axe Y1, comme illustré par la flèche F6.

De cette manière, l'organe 183 est déplacé hors du logement vers sa position libérée, à l'écart de la paroi de retenue 185. Alors, sous l'effet de la première force de rappel élastique exercée par la lame 181, la languette 180 remonte le long de l'axe X1' vers la position de verrouillage, jusqu'à ce que le crochet 187 engage la branche inférieure 212 du rail 2. Parallèlement, la deuxième force de rappel ramène la portion principale de la languette 180 alignée avec l'axe X1'.

Grâce à cette configuration du dispositif 18, le déplacement vers la position de verrouillage est plus simple et plus intuitif à réaliser pour un opérateur. L'ergonomie du dispositif 18 est là aussi améliorée.

Selon une variante, de façon analogue à ce qui est décrit en référence au dispositif 16, le dispositif 18 peut être réalisé sur une partie supérieure de l'appareil 1'.

En variante, l'appareil 1 peut comporter plusieurs exemplaires du dispositif de verrouillage 16, par exemple lorsque les dimensions de cet appareil 1 nécessitent plusieurs points d'attache à un ou plusieurs rails de fixation 2. Il en va de même pour l'appareil 1' en référence au dispositif de verrouillage 18.

La figure 9 représente un appareil électrique 1" selon une variante du premier mode de réalisation de l'invention. Les éléments de l'appareil électrique 1" qui sont analogues à ceux de l'appareil 1 portent des références numériques augmentées du symbole « " » et ne sont pas décrits en détail, dans la mesure où la description ci-dessus peut leur être transposée. On note notamment « X1" » et « Y1" » des axes fixes analogues aux axes X1 et Y1 de l'appareil 1, et « P" » un plan géométrique médian analogue au plan P de l'appareil 1.

En particulier, l'appareil 1" est similaire à l'appareil 1 et n'en diffère que par certaines différences de forme et d'agencement. Notamment, la portion de manœuvre 163" dépasse par rapport à la base du boîtier de l'appareil 1". La lame 162" relie la partie principale 10" à la partie supérieure de la partie principale de la languette 160", tout en se trouvant sous la lame 161".

Avantageusement, l'appareil 1" comporte une ou plusieurs butées de fin de course adaptées pour limiter le débattement de la portion 163" selon l'axe X1" et/ou selon l'axe Y1". Cela permet d'éviter un déplacement excessif de la portion 163" pour éviter de dépasser la limite élastique du matériau plastique. La ou les butée(s) de fin de course peuvent être aussi mises en œuvre sur l'appareil 1 ou sur l'appareil 1'.

Les modes de réalisation et les variantes envisagés ci-dessus peuvent être combinés entre eux pour générer de nouveaux modes de réalisation, dans le cadre des revendications annexées.

## Revendications

1. Appareil électrique (1) adapté pour être monté sur un rail de fixation (2), cet appareil électrique comportant :
- un boîtier, comprenant une partie centrale (10) et un couvercle latéral (11) monté sur la partie centrale ;
- un dispositif de verrouillage (16) bistable, comportant :
• une languette (160) déplaçable en translation le long d'un premier axe (X1) entre une position de verrouillage, adaptée pour maintenir l'appareil électrique (1) attaché sur un rail de fixation (2), et une position de déverrouillage, adaptée pour autoriser le déplacement de l'appareil électrique (1) par rapport au rail de fixation (2) ;
• une lame élastiquement déformable (161, 162) qui relie la languette (160) à la partie centrale (10) du boîtier et qui est adaptée pour exercer une première force de rappel élastique sur la languette (160) depuis la position de déverrouillage vers la position de verrouillage ;
la languette (160) comporte en outre un organe de verrouillage (164) ménagé sur une face latérale de la languette (160) et qui s'étend en saillie par rapport à cette face latérale selon un deuxième axe (Y1) perpendiculaire au premier axe (X1), ce deuxième axe (Y1) formant un axe transversal de l'appareil (1) ;
l'appareil électrique (1) comporte, ménagé sur une face intérieure du couvercle (11), une paroi de retenue (1661) qui délimite au moins en partie un logement (1660) de forme complémentaire à l'organe de verrouillage, la face intérieure étant tournée vers l'organe de verrouillage (164) et le logement étant situé en regard de l'organe de verrouillage (164),
et l'organe de verrouillage (164) est déplaçable, en subissant un débattement élastique selon une direction de débattement (Z1) perpendiculaire au premier axe (X1) et au deuxième axe (Y1), entre une position retenue à l'intérieur du logement (1660), dans laquelle la paroi de retenue (1661) maintient la languette (160) dans la position de déverrouillage, en empêchant un déplacement de l'organe de verrouillage en translation selon le premier axe (X1), et une position libérée en dehors du logement (1660), dans laquelle l'organe de verrouillage autorise un déplacement en translation de la languette (160) selon le premier axe (X1).

2. Appareil selon la revendication 1, **caractérisé en ce que** la languette (160) est en outre apte à subir un débattement élastique selon la direction de débattement (Z1), le dispositif de verrouillage (16) comportant une lame déformable additionnelle (162), reliant la languette (160) à la partie centrale (10) du boîtier, cette lame étant adaptée pour exercer une deuxième force de rappel sur la languette (160) selon cette direction de débattement lorsqu'elle subit un tel débattement et présentant à cet effet une forme recourbée.

3. Appareil selon la revendication 2, **caractérisé en ce que** le dispositif (16) comporte en outre une paroi inclinée (1662) agencée pour dévier l'organe de verrouillage selon la direction de débattement (Z1) lorsque la languette (160) se déplace vers la position de déverrouillage.

4. Appareil selon la revendication 2 ou 3, **caractérisé en ce que** le deuxième axe (Y1) est parallèle à un axe longitudinal du rail de fixation (2).

5. Appareil selon l'une des revendications précédentes, **caractérisé en ce que** le dispositif de verrouillage (16) comporte une pièce complémentaire (166) qui s'étend en saillie par rapport à la face intérieure du couvercle latéral (11) selon le deuxième axe (Y1) et qui comporte la paroi de retenue (1661), le logement (1660) étant ménagé au sein de la pièce complémentaire (166) et présentant une forme de cavité ouverte.

6. Appareil selon l'une des revendications précédentes, **caractérisé en ce que** le dispositif de verrouillage (16) est réalisé d'un seul tenant avec la partie centrale (10) du boîtier de l'appareil (1).

7. Appareil selon l'une des revendications précédentes, **caractérisé en ce que** l'appareil comporte un crochet mobile (165) solidaire de la languette (160) et un crochet fixe (15), le crochet fixe et le crochet mobile étant adaptés pour coopérer avec des branches (211 ; 212) du rail de fixation (2).

8. Appareil selon l'une des revendications précédentes, **caractérisé en ce que** la languette (160) comporte une portion de manœuvre (163) dépassant à l'extérieur du boîtier pour commander le déplacement de la languette par un opérateur.

9. Appareil selon l'une des revendications précédentes, **caractérisé en ce que** l'appareil électrique (1) est un porte-fusible.

## Patentansprüche

1. Elektrisches Gerät (1) zur Montage auf einer Befestigungsschiene (2), wobei dieses elektrische Gerät aufweist:
- ein Gehäuse, das einen mittleren Teil (10) und einen seitlichen Deckel (11), der auf dem mittleren Teil montiert ist, umfasst;
- eine bistabile Verriegelungsvorrichtung (16), mit:
• einer Zunge (160), die entlang einer ersten Achse (X1) translatorisch bewegbar ist zwischen einer Verriegelungsposition, die eingerichtet ist, um das elektrische Gerät (1) auf einer Befestigungsschiene (2) angebracht zu halten, und einer Entriegelungsposition, die eingerichtet ist, um die Bewegung des elektrischen Geräts (1) relativ zu der Befestigungsschiene (2) zu gestatten;
• einem elastisch verformbaren Blatt (161, 162), das die Zunge (160) mit dem mittleren Teil (10) des Gehäuses verbindet und das eingerichtet ist, um eine erste Rückstellfederkraft auf die Zunge (160) aus der Entriegelungsposition in die Verriegelungsposition auszuüben;
wobei die Zunge (160) ferner ein Verriegelungselement (164) aufweist, das auf einer seitlichen Fläche der Zunge (160) angeordnet ist und das sich relativ zu dieser seitlichen Fläche entlang einer zweiten Achse (Y1) senkrecht zu der ersten Achse (X1) hervorstehend erstreckt, wobei diese zweite Achse (Y1) eine Querachse des Geräts (1) bildet;
wobei das elektrische Gerät (1) eine auf einer inneren Fläche des Deckels (11) angeordnete Rückhaltewand (1661) aufweist, die zumindest teilweise eine Aufnahme (1660) mit zu dem Verriegelungselement komplementärer Form bildet, wobei die innere Fläche dem Verriegelungselement (164) zugewandt ist und die Aufnahme dem Verriegelungselement (164) gegenüberliegend angeordnet ist,
und wobei das Verriegelungselement (164) bewegbar ist, indem es eine federnde Auslenkung entlang einer Auslenkungsrichtung (Z1) senkrecht zu der ersten Achse (X1) und zu der zweiten Achse (Y1) erfährt, zwischen einer Rückhalteposition im Inneren der Aufnahme (1660), in der die Rückhaltewand (1661) die Zunge (160) in der Entriegelungsposition hält, indem sie eine translatorische Bewegung des Verriegelungselements entlang der ersten Achse (X1) verhindert, und einer Freigabeposition außerhalb der Aufnahme (1660), in der das Verriegelungselement eine translatorische Bewegung der Zunge (160) entlang der ersten Achse (X1) gestattet.

2. Gerät nach Anspruch 1, **dadurch gekennzeichnet, dass** die Zunge (160) ferner in der Lage ist, eine federnde Auslenkung entlang der Auslenkungsrichtung (Z1) zu erfahren, wobei die Verriegelungsvorrichtung (16) ein zusätzliches verformbares Blatt (162) aufweist, das die Zunge (160) mit dem mittleren Teil (10) des Gehäuses verbindet, wobei dieses Blatt eingerichtet ist, um eine zweite Rückstellfederkraft auf die Zunge (160) entlang dieser Auslenkungsrichtung auszuüben, wenn sie eine derartige Auslenkung erfährt, und zu diesem Zweck eine gekrümmte Form aufweist.

3. Gerät nach Anspruch 2, **dadurch gekennzeichnet, dass** die Vorrichtung (16) ferner eine geneigte Wand (1662) aufweist, die ausgebildet ist, um das Verriegelungselement entlang der Auslenkungsrichtung (Z1) umzulenken, wenn sich die Zunge (160) in die Entriegelungsrichtung bewegt.

4. Gerät nach Anspruch 2 oder 3, **dadurch gekennzeichnet, dass** die zweite Achse (Y1) zu einer Längsachse der Befestigungsschiene (2) parallel ist.

5. Gerät nach einem der vorhergehenden Ansprüche, **dadurch gekennzeichnet, dass** die Verriegelungsvorrichtung (16) ein komplementäres Teil (166) aufweist, das sich relativ zu der inneren Fläche des seitlichen Deckels (11) entlang der zweiten Achse (Y1) hervorstehend erstreckt und das die Rückhaltewand (1661) aufweist, wobei die Aufnahme (1660) innerhalb des komplementären Teils (166) gebildet ist und die Form einer offenen Vertiefung aufweist.

6. Gerät nach einem der vorhergehenden Ansprüche, **dadurch gekennzeichnet, dass** die Verriegelungsvorrichtung (16) einstückig mit dem mittleren Teil (10) des Gehäuses des Geräts (1) ausgebildet ist.

7. Gerät nach einem der vorhergehenden Ansprüche, **dadurch gekennzeichnet, dass** das Gerät einen beweglichen Haken (165), der mit der Zunge (160) fest verbunden ist, und einen unbeweglichen Haken (15) aufweist, wobei der unbewegliche Haken und der bewegliche Haken eingerichtet sind, um mit Schenkeln (211; 212) der Befestigungsschiene (2) zusammenzuwirken.

8. Gerät nach einem der vorhergehenden Ansprüche, **dadurch gekennzeichnet, dass** die Zunge (160) einen Betätigungsabschnitt (163) aufweist, der aus dem Gehäuse heraussteht, um die Bewegung der Zunge durch einen Bediener zu steuern.

9. Gerät nach einem der vorhergehenden Ansprüche, **dadurch gekennzeichnet, dass** das elektrische Gerät (1) ein Sicherungshalter ist.

## Claims

1. An electrical apparatus (1) capable of being mounted on an attachment rail (2), this electrical apparatus including:
- a casing, comprising a central part (10) and a side cover (11) mounted on the central part;
- a bistable locking device (16), including:
• a tab (160) translatable along a first axis (X1) between locked position, suitable for keeping the electrical apparatus (1) attached on an attachment rail (2), and an unlocked position, suitable for allowing the movement of the electrical apparatus (1) relative to the attachment rail (2);
• a resiliently deformable blade (161, 162) that connects the tab (160) to the central part (10) of the casing and that is suitable for exerting a first resilient return force on the tab (160) from the unlocked position toward the locked position;
the tab (160) further includes a locking member (164) arranged on a side face of the tab (160) and that protrudes relative to this side face along a second axis (Y1) perpendicular to the first axis (X1), this second axis (Y1) forming a transverse axis of the apparatus (1);
the electrical apparatus (1) includes, arranged on an inner face of the cover (11), a retaining wall (1661) that delimits at least part of a housing (1660) with a shape complementary to the locking member, the inner face facing the locking member (164) and the housing being situated across from the locking member (164),
and the locking member (164) is movable, by undergoing a resilient travel in a direction of travel (Z1) perpendicular to the first axis (X1) and the second axis (Y1), between a retained position inside the housing (1660), in which the retaining wall (1661) keeps the tab (160) in the locked position, by preventing a movement of the locking member in translation along the first axis (X1), and a released position outside the housing (1660), in which the locking member allows a translational movement of the tab (160) along the first axis (X1).

2. The apparatus according to claim 1, **characterized in that** the tab (160) is further able to undergo a resilient travel in the travel direction (Z1), the locking device (16) including an additional deformable blade (162), connecting the tab (160) to the central part (10) of the casing, this blade being suitable for exerting a second return force on the tab (160) in this travel direction when it undergoes such travel and to that end having a curved shape.

3. The apparatus according to claim 2, characterized int hat the device (16) further includes an inclined wall (1662) arranged to deflect the locking member in the travel direction (Z1) when the tab (160) moves toward the unlocked position.

4. The apparatus according to claim 2 or 3, **characterized in that** the second axis (Y1) is parallel to a longitudinal axis of the attachment rail (2).

5. The apparatus according to one of the preceding claims, **characterized in that** the locking device (16) includes an additional part (166) that protrudes relative to the inner face of the side cover (11) along the second axis (Y1) and that includes the retaining wall (1661), the housing (1660) being arranged within the complementary part (166) and having an open cavity shape.

6. The apparatus according to one of the preceding claims, **characterized in that** the locking device (16) is made in one piece with the central part (10) of the casing of the apparatus (1).

7. The apparatus according to one of the preceding claims, **characterized in that** the apparatus includes a movable hook (165) secured to the tab (160) and a stationary hook (15), the stationary hook and the movable hook being suitable for cooperating with branches (211; 212) of the attachment rail (2).

8. The apparatus according to one of the preceding claims, **characterized in that** the tab (160) includes a maneuvering portion (163) protruding outside the casing for control of the movement of the tab by an operator.

9. The apparatus according to one of the preceding claims, **characterized in that** the electrical apparatus (1) is a fuse holder.
